# FASCICULE DE BREVET EUROPEEN

(11) **EP 2 887 086 B1**
(45) Date de publication et mention de la délivrance du brevet: **23.08.2017**
(21) Numéro de dépôt: 14198979.8
(22) Date de dépôt: 18.12.2014
(51) Int. Cl.: G01R 33/02, G01R 33/038

(54) **CAPTEUR MULTI-SENSORIEL**
MULTISENSORISCHER MESSWERTAUFNEHMER
MULTI-SENSORY SENSOR

(30) Priorité: 20.12.2013 FR 1363189
(43) Date de publication de la demande: 24.06.2015
(73) Titulaire: COMMISSARIAT À L'ÉNERGIE ATOMIQUE ET AUX ÉNERGIES ALTERNATIVES, 75015 Paris (FR)
(72) Inventeur: Jourdan, Guillaume, 38000 Grenoble (FR); Diem, Bernard, 38130 Èchirolles (FR); Rey, Patrice, 38430 St Jean de Moirans (FR); Robert, Philippe, 38000 Grenoble (FR)
(74) Mandataire: Decobert, Jean-Pascal

(56) Documents cités:
- FR-A1- 2 924 422
- US-A1- 2012 166 122

## Description

### DOMAINE DE L'INVENTION

La présente invention est relative à l'industrie de la microélectronique, qui couvre aussi bien les techniques de la microélectronique que de la nanoélectronique. En particulier, l'invention concerne un capteur multisensoriel pour un microsystème électromécanique (en anglais « MEMS » pour « microelectromechanical system ») ou un nanosystème électromécanique (en anglais « NEMS » pour « nanoelectromechanical system »).

### ARRIERE-PLAN TECHNOLOGIQUE

Le marché grand public des capteurs multi-sensoriels de type accéléromètre 3 axes, magnétomètre 3 axes, gyromètre 3 axes et capteur de pression, s'oriente vers des tailles de composants toujours petites pour atteindre un coût compétitif.

Ainsi, la taille d'un capteur à 9 axes, incluant une puce de silicium de type microsystème électromécanique (en anglais « MEMS » pour « microelectromechanical system »), l'électronique de traitement de signal comprenant le circuit intégré propre à une application (acronyme « ASIC » en anglais pour « Application-Specific Integrated Circuit ») et le package, est actuellement de dimension 4 x 4 mm² (mm = millimètre) et atteindra très prochainement 3 x 3 mm². Ces dimensions requièrent une taille pour la puce de silicium seule de l'ordre de 4 mm². Dans ce contexte de contraintes drastiques d'encombrement, la réalisation de structures MEMS comportant 6, 9 voire 10 axes de mesure (ou mesurandes) et exigeant un nombre de plots important pour réaliser l'interconnexion avec l'électronique de lecture de chaque axe, peut, dans certains cas, apparaître rédhibitoire. Cela conduirait, en effet, à une taille de composants plus grande que l'espace nécessaire pour placer les structures MEMS, donc un coût de production beaucoup trop important.

Généralement, les éléments considérés comme sensibles occupent moins de 25% de la taille totale de la puce de silicium. L'essentiel de la surface est dédié aux pistes d'acheminement des signaux (alimentation, détection), aux plots de connexion de la puce aux composants extérieurs (ASIC), au cordon de scellement recevant un substrat additionnel destiné à former un capot de protection.

Par exemple, dans un capteur à 6 axes de mesure (tel un capteur comprenant des accéléromètres 3 axes et des gyromètres 3 axes), chacun des axes est détecté par un pont de Wheatstone. Les trois ponts de Wheatstone requis pour les accéléromètres sont connectés à des alimentations distinctes; de même que les trois ponts de Wheatstone requis pour les gyromètres. Pour s'affranchir de l'influence des dipôles parasites extérieurs au pont, on effectue une mesure de la tension aux bornes de chaque pont. A cela, s'ajoutent pour chaque gyromètre, deux plots d'actionnement et d'asservissement de la masse sismique, et, pour les accéléromètres, un plot d'autotest. Ce système requiert au minimum 4 plots pour l'alimentation, 12 plots pour les mesures des tensions d'alimentation aux bornes de chaque pont, 12 plots pour les mesures des déséquilibres de chaque pont, 6 plots pour l'actionnement et l'asservissement des masses sismiques des gyromètres et un plot pour l'autotest des accéléromètres. On arrive ainsi à un nombre total minimum de 35 plots, souvent répartis pour des contraintes de fabrication, sur deux côtés de la puce. Pour un pas typique entre plots de 200 micron (µm = micromètre = 10⁻⁶ mètre), une des dimensions de la puce est au minimum de 3.6 millimètres. Pour une dimension minimum suivant l'autre direction de l'ordre de 1.5 à 2 millimètres, on arrive à une taille minimum de puce comprise entre 5.4 et 7.2 mm² alors que la dimension des produits actuellement disponibles avec une détection de type capacitif est déjà inférieure à 5 mm² et que la tendance s'oriente vers des dimensions encore plus petites. La réalisation des plots peut donc être un facteur limitant pour réduire la taille du composant MEMS.

II existe aussi un besoin pour limiter la consommation électrique qui est élevée dans les montages à Ponts de Wheatstone actuels.

Le document US 2012 0166122 A1 divulgue un circuit de lecture avec compensation d'offset, pour un capteur de champ magnétique. Selon un aspect, ce document divulgue un pont de Wheatstone pour mesurer un champ magnétique d'éléments magnéto-résistifs anisotropes. Une compensation d'offset est proposée avec un couplage magnétique des éléments magnéto-résistifs du capteur avec des organes dits « offset strapts », appliquant un champ magnétique bref mais fort aux éléments magnéto-résistifs.

Le document D2 montre un dispositif de détection à jauge suspendue à pont de Wheatstone traditionnel.

Ces documents n'apportent aucune solution en termes d'encombrement ou de simplicité en cas de multiplication d'axes de détection dans un capteur.

Un objet de la présente invention est de proposer un capteur multisensoriel optimisant les connexions notamment afin de limiter la taille des composants.

De manière particulièrement avantageuse, l'invention vise également à réduire la consommation énergétique d'un tel capteur.

### RESUME DE L'INVENTION

L'invention concerne un circuit de mesure pour un capteur multi-sensoriel caractérisé en ce qu'il comprend :
- une pluralité de branches de détection montées en parallèle, chacune comprenant au moins deux dipôles montés en série,
- et, au moins une branche de référence, comprenant une source de polarisation et au moins deux dipôles montés en série; ladite branche de référence étant reliée en parallèle à au moins deux branches de détection parmi la pluralité de branches, de sorte à former un pont de Wheatstone avec chacune des branches de détection parmi la pluralité de branches de détection.

L'invention concerne également un capteur multi-sensoriel comprenant au moins un circuit de mesure selon l'invention.

L'invention met en oeuvre un montage qualifié de multi-pont, consistant à connecter une branche de référence à une pluralité de branches de détection afin de partager la même source de polarisation, et ainsi réduire la consommation énergétique.

Le montage proposé offre également une solution pour minimiser le nombre de plots présents sur un microsystème électromécanique. Les plots sont des moyens d'accès afin de réaliser les mesures des variations d'impédance d'un dipôle. Cette solution repose sur le partage de plots d'accès entre les différentes branches de détection comprenant les dipôles qui constituent chacune un mesurande. L'interconnexion des branches de détection est préférentiellement réalisée sur un substrat, comprenant un système de type MEMS ou NEMS

### BREVE INTRODUCTION DES FIGURES

D'autres caractéristiques, buts et avantages de la présente invention ressortiront mieux de la description détaillée de modes de réalisation de cette dernière, qui sont illustrés par les dessins d'accompagnement suivants dans lesquels :
La FIGURE 1 illustre une représentation schématique d'un capteur multisensoriel selon l'art antérieur, requérant autant de sources de polarisation que de mesurandes. Chaque branche de détection comprend un dipôle à impédance variable en fonction de l'évolution d'un mesurande.
La FIGURE 2 illustre une représentation schématique d'un capteur multisensoriel selon l'art antérieur, requérant autant de sources de polarisation que de mesurandes. Chaque branche de détection comprend deux dipôles à impédance variable en fonction de l'évolution d'un mesurande.
La FIGURE 3 illustre une représentation schématique d'un capteur multisensoriel selon l'invention requérant une source de polarisation pour une pluralité de mesurandes. A chaque branche de détection est associé un mesurande.
Les FIGURE 4 à 6 illustrent des représentations schématiques d'un capteur multisensoriel selon l'invention requérant une source de polarisation pour une pluralité de mesurandes. A chaque branche de détection est associé un mesurande et un plot de mesure.
La FIGURE 7 illustre une représentation schématique d'un capteur multisensoriel selon l'invention. Dans ce mode de réalisation, les plots de mesure additionnels (ou d'accès) sont positionnés sur un substrat additionnel.
La FIGURE 8 illustre un capteur multi-sensoriel à deux mesurandes. Dans ce cas, cinq plots sont positionnés sur le substrat additionnel.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DETAILLEE

Avant d'entamer une revue détaillée de modes de réalisation de l'invention, sont énoncées ci-après des caractéristiques optionnelles qui peuvent éventuellement être utilisées en association ou alternativement :
Avantageusement, le circuit comprend au moins un dipôle à impédance variable en fonction de l'évolution d'un mesurande, dans au moins une branche de détection.

La branche de référence est reliée aux branches de détection, soit directement, soit au moyen d'un premier plot et d'un deuxième plot de polarisation.

De manière particulièrement avantageuse, chaque branche de détection est reliée à au moins un plot de mesure central situé entre les dipôles de ladite branche de détection, au point milieu des branches de détection.

De préférence, deux plots de mesure additionnels sont montés en parallèle et configurés de sorte à contrôler la tension de polarisation des branches de détection.

De manière particulièrement avantageuse, le capteur multi-sensoriel comprend au moins le circuit de mesure.

Avantageusement, le circuit de mesure est formé en partie au moins sur un premier substrat et un deuxième substrat; lesdits substrats étant assemblés de sorte à former une cavité.

Lorsque la branche de référence est reliée en parallèle aux branches de détection au moyen du premier plot et du deuxième plot de polarisation, avantageusement, l'un au moins parmi lesdits plots de mesure, plots de mesure centraux et plots de mesure additionnels est situé sur le premier substrat et/ou sur le deuxième substrat.

Avantageusement la branche de référence est, en partie au moins, positionnée sur le premier substrat et/ou, en partie au moins, positionnée sur le deuxième substrat.

Préférentiellement, chaque branche de détection est en partie au moins positionnée sur le premier substrat.

Avantageusement, chaque branche de détection est reliée à au moins un plot de mesure central; ledit plot de mesure étant situé sur le deuxième substrat ou le premier substrat.

Selon un mode de réalisation particulièrement avantageux, le capteur comprend un microsystème et/ou nanosystème électromécanique.

Avantageusement, le microsystème et/ou nanosystème électromécanique est situé dans la cavité.

Préférentiellement, le microsystème et/ou nanosystème électromécanique comporte au moins une masse mobile.

Selon un mode de réalisation préférentiel, le microsystème et/ou nanosystème électromécanique est réalisé sur le premier substrat.

Avantageusement, le premier substrat et/ou le deuxième substrat comprend(/ent) des pistes d'interconnexion.

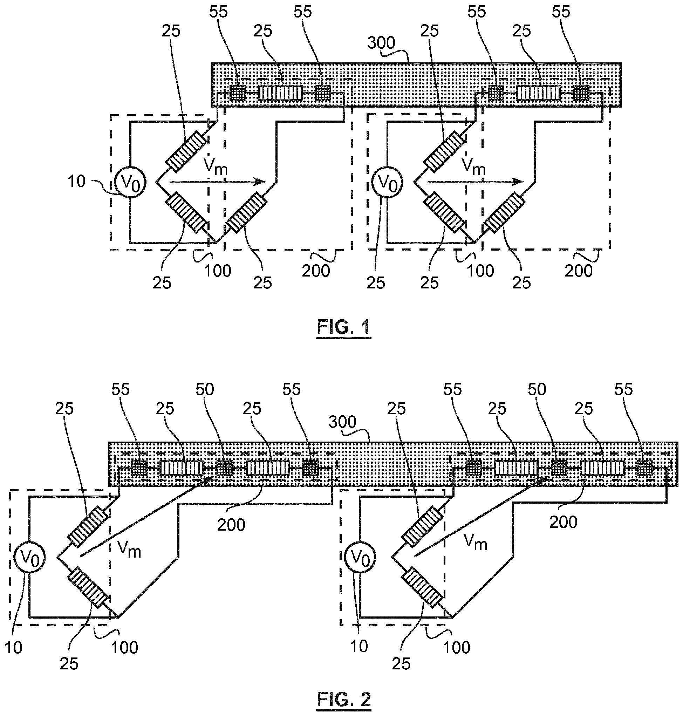

La **figure 1** illustre un circuit électrique conventionnel associé à un capteur à deux mesurandes. Un mesurande est une grandeur physique d'entrée transformée en une autre grandeur physique de sortie ou en un signal électrique. Les grandeurs physiques peuvent être, par exemple, de type mécanique (déplacement, force, masse, débit), thermique (température, capacité thermique, flux thermique), électrique (courant, tension, charge, impédance, diélectrique), magnétique (champ magnétique), radiatif (lumière visible, rayons X, micro-ondes) ou encore (bio-)chimique (humidité, gaz).
Le circuit de mesure, selon cette réalisation, comprend plusieurs branches de référence 100. Chaque branche de référence 100 comprend une source de polarisation 10 et au moins deux dipôles 25 montés en série. Le circuit comprend également des branches de détection 200. Chaque branche de détection 200 comprend au moins deux dipôles 25 montés en série. Pour chaque mesurande, une branche de référence 100 est associée à une branche de détection 200 de sorte à former un pont de Wheatstone.
Dans ce cas, un des dipôles 25 de la branche de détection 200 représente un transducteur passif c'est-à-dire un dipôle à impédance variable pouvant être résistif, capacitif ou inductif. Le nombre de plots 55 à mettre en oeuvre par mesurande est de deux : un premier plot 55 est configuré de sorte à injecter le courant de polarisation tandis qu'un deuxième plot 55 est configuré de sorte à extraire le courant de polarisation.
Dans ce contexte, si l'on considère n mesurandes, le nombre de plots 55, nécessaires pour permettre la lecture de chaque transducteur avantageusement passif 25, est égal à 2 x n. Par exemple, pour un capteur ayant 10 axes soit 10 mesurandes, 20 plots 55 de connexion sont alors requis.

Les dipôles 25 peuvent être lus à l'aide d'un montage en pont de Wheatstone, à partir de la tension de sortie *Vₘ.* La branche de référence 100 qui génère le potentiel de référence est, dans cet exemple de configuration, entièrement réalisée en dehors du substrat 300. Avantageusement, le substrat 300 comprend une puce de type microsystème électromécanique (acronyme MEMS en anglais pour MicroElectroMechanical System). Seule la moitié de la branche de détection 200 est présente sur le substrat 300.

La **figure 2** illustre un circuit électrique comprenant un capteur où chaque branche de détection 200 possède deux transducteurs avantageusement passifs 25 soumis à des mesurandes opposés. Cette stratégie de détection différentielle est souvent privilégiée car elle permet avantageusement d'éliminer les variations d'impédance identiques produites par des grandeurs d'influence telles que la température, à l'aide d'un pont de Wheatstone.

Lorsque deux transducteurs avantageusement passifs 25 sont présents sur un capteur, le nombre de plots 50, 55 à mettre en oeuvre par mesurande est de trois : un premier plot 55 est configuré de sorte à injecter le courant de polarisation, un deuxième plot 55 pour extraire le courant de polarisation et un troisième plot de mesure central 50 pour la lecture du déséquilibre du pont.

Dans ce contexte, si l'on considère n mesurandes, le nombre de plots 50, 55 nécessaires pour permettre la lecture de chaque transducteur passif 25 est de 3 x n. Par exemple, pour un capteur ayant 10 axes soit 10 mesurandes, 30 plots 50, 55 sont alors requis.

Les dipôles 25 peuvent être lus à l'aide d'un montage en pont de Wheatstone, à partir de la tension de sortie *Vₘ.* La branche de référence 100 qui génère le potentiel de référence est, dans cet exemple de configuration, entièrement réalisée en dehors du substrat 300. Au contraire, la branche de détection 200 est réalisée à partir du substrat 300.

Les montages des figures 1 et 2 selon l'art antérieur possèdent tous autant de branches de référence 100 que de mesurandes, et donc que de branches de détection 200.
Pour un mode de lecture continu pour lequel l'ensemble des transducteurs avantageusement passifs 25 doit être polarisé simultanément, les branches de référence 100 sont toutes traversées par un courant électrique. La consommation d'énergie étant une fonction croissante relativement au nombre de branches de référence 100 polarisées (sous réserve que ces branches possèdent les mêmes dipôles 25; ce qui est en général le cas, car il est préférable d'utiliser les mêmes dipôles transductifs afin qu'ils soient sensibles aux mêmes grandeurs d'influence), l'invention propose de réduire ce nombre de branches de référence 100.
Selon un exemple de réalisation, pour un courant générant 100 micro-ampères (µA) et des dipôles de 4000 Ohms (Ω), la puissance dissipée par effet Joule s'élève à 40 micro-Watts (µW). Les solutions typiques discutées dans les paragraphes précédents requièrent alors une puissance de 80 µW pour réaliser la polarisation d'un mesurande.

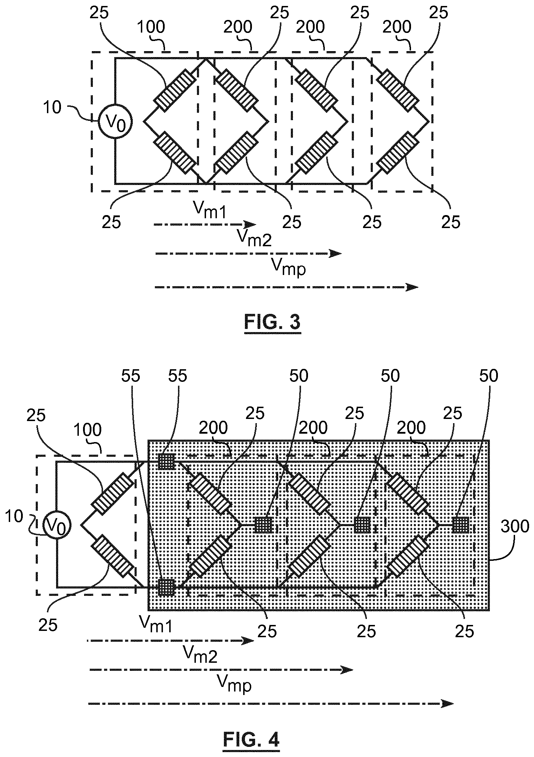

Les **figures 3** à **8** illustrent des modes de réalisation selon la présente invention.
La **figure 3** présente un schéma de principe d'un montage de type multi-pont, consistant à connecter entre elles, selon un pont de Wheatstone, une pluralité de branches de détection 200 comprenant au moins un transducteur passif 25 de sorte à ce que la pluralité de branches de détection 200 partage une source commune de polarisation 10 d'une branche de référence 100.
Le signal de mesure *Vₘ* pour chaque mesurande correspond à la tension différentielle entre le point milieu de la branche dite de référence 100 (les impédances étant sensibles ou non à un mesurande ou à des grandeurs d'influence) et le point milieu d'une branche de détection 200 ; ladite branche 200 étant munie d'au moins un transducteur passif 25, associé à un mesurande. L'invention propose, entre autres, de mettre en commun une même branche de référence 100 pour générer le potentiel de référence Vₒ utilisé par toutes les branches de détection 200.

Ceci a notamment pour effet de réduire le courant électrique débité par la source de polarisation 10 en comparaison avec la situation où autant de branches de référence 100 (soit de sources de polarisation 10) que de mesurandes (soit de branches de détection 200) peuvent être introduites.

La consommation d'énergie d'un tel montage se trouve ainsi réduite d'un facteur proche de deux lorsque le nombre de mesurandes augmente. Selon des exemples de réalisation non limitatifs de l'invention, pour un dispositif à deux mesurandes, le montage nécessite uniquement trois branches à polariser (soit une branche de référence 100 et deux branches de détection 200) au lieu de quatre branches 100, 200 nécessaires dans le montage selon l'art antérieur. Pour un dispositif à sept mesurandes, le montage selon l'invention nécessitera uniquement huit branches à polariser (soit une branche de référence 100 et sept branches de détection 200) au lieu de quatorze branches 100, 200 nécessaires dans le montage selon l'art antérieur.

La **figure 4** illustre la mise en commun de plots 55 de polarisation pour des capteurs possédant chacun deux transducteurs avantageusement passifs 25. La figure 4 montre notamment la disposition des transducteurs avantageusement passifs 25 et d'une pluralité de plots 50, 55. Deux plots 55 parmi la pluralité de plots 50, 55 permettent de polariser les branches de détection 200 associées à chaque axe de détection. Ces deux plots 55 sont avantageusement connectés à la source de polarisation 10. Le signal de mesure *Vₘ* pour chaque mesurande est construit sur la différence de potentiel entre le point milieu de chaque branche de détection 200 et le point milieu de la branche de référence 100. Un plot de mesure central 50 est ainsi positionné au niveau du point milieu de chaque branche de détection 200, afin d'extraire un mesurande pour chaque branche de détection 200. Dans ce mode de configuration, l'interconnexion des branches de détection 200 est réalisée sur le substrat 300. Le nombre de plots 50, 55 nécessaire pour interfacer le substrat 300 c'est-à-dire le microsystème électromécanique avec un dispositif externe (par exemple, un autre substrat, des sources d'alimentation, etc.) est alors égal à n + 2, où n est le nombre de mesurandes.

Lorsqu'un seul transducteur 25 est présent sur chaque branche de détection 200, seul un des deux plots 55 peut être partagé entre les différents mesurandes. Cela permet de réduire le nombre de plots 50, 55 à n + 1 (où n est le nombre de mesurandes) au lieu de 2 x n pour la solution connue de l'art antérieur. Avantageusement, ce dispositif conduit à une réduction de n - 1 plots 50, 55. Selon un exemple de configuration, pour un dispositif à 10 mesurandes, uniquement 11 plots 50, 55 sont avantageusement nécessaires, selon l'invention, contre 20 plots 50, 55 requis, selon l'art antérieur. Dans le cas où deux transducteurs par axe de détection sont présents, deux plots 55 peuvent être mis en commun pour chaque branche de détection 200. Ainsi, cela permet de réduire le nombre de plots 50, 55 à n + 2 (où n est le nombre de mesurandes) au lieu de 3 x n pour la solution connue de l'art antérieur, ce qui conduit à une réduction avantageuse de 2 x (n - 1) plots 50, 55. Selon un exemple de configuration, pour un dispositif à 10 mesurandes, uniquement 12 plots 50, 55 sont nécessaires, selon l'invention, contre 30 plots 50, 55 requis, selon l'art antérieur.

Dans les deux cas précédents, un gain important peut, de manière particulièrement avantageuse, être obtenu en termes de nombre de plots de polarisation 55 et de plots de mesure centraux 50, en particulier lorsque le nombre de mesurandes, au niveau du substrat 300 comprenant préférentiellement un microsystème électromécanique (MEMS), devient important. L'invention ne se limite pas aux microsystèmes électromécaniques mais s'applique également aux nanosystèmes électromécaniques (NEMS).

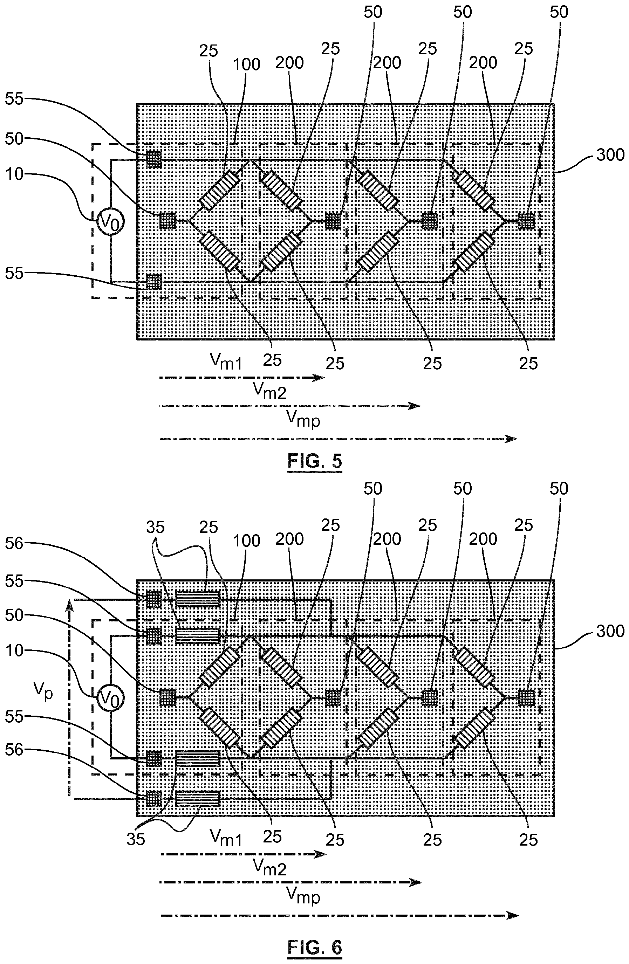

La **figure 5** illustre un montage selon la présente invention dans lequel la branche de référence 100 est intégrée au substrat 300 c'est-à-dire au microsystème électromécanique. La branche de référence 100 est, avantageusement, alimentée par les mêmes plots 55 que les branches de détection 200. Un plot de mesure central 50 supplémentaire est nécessaire pour atteindre le point milieu de la branche de référence 100 qui génère le potentiel de référence. Le nombre de plots 50, 55 requis est ainsi égal, dans ce mode de réalisation, à n + 3, où n est le nombre de mesurandes.
La branche de référence 100 permet de reproduire le potentiel des branches de détection 200 associées à chaque mesurande lorsque ces derniers sont au repos. La branche de référence 100, intégrée au substrat 300 comprenant un microsystème électromécanique, est ainsi placée à proximité des différents capteurs. Cette branche de référence 100 peut, selon un mode de réalisation particulièrement avantageux, être connectée au reste du montage au moyen de pistes électriques présentes, par exemple, sur le substrat 300, avantageusement sur le microsystème électromécanique.

Cette configuration présente plusieurs avantages. La branche de référence 100 peut avantageusement être réalisée avec les mêmes transducteurs avantageusement passifs 25 que les branches de détection 200. La branche de référence 100 possédera ainsi, de manière avantageuse, un comportement similaire, voire identique, aux branches de détection 200 vis-à-vis des grandeurs d'influence. De plus, les pistes associées aux potentiels de milieu de pont des branches de détection 200 et de la branche de référence 100 peuvent avantageusement être maintenues proches l'une de l'autre. Cette disposition favorise, entre autres, une réduction de la sensibilité aux perturbations électromagnétiques qui affectent le mode différentiel des signaux de mesure (par exemple, les boucles d'induction, le couplage capacitif, le couplage inductif, etc.).
De manière particulièrement avantageuse, en présence de dipôle d'accès extra-pont aux transducteurs avantageusement passifs (dipôles parasites), le potentiel du milieu de pont de la branche de référence 100 sera modifié de la même manière que le potentiel *Vₘ* des branches de détection 200.

Dans la plupart des modes de réalisation, la branche de référence 100 est insensible à l'un des mesurandes du capteur multi-sensoriel. De manière particulièrement avantageuse, il est envisageable, selon la présente invention, de rendre sensible la branche de référence 100 à un de ces mesurandes de sorte à soustraire ce même mesurande à un autre mesurande. Par exemple, sur un capteur de mouvements accélérométriques et magnétométriques tridimensionnels (soit un capteur 6 axes : accéléromètre 3 axes et magnétomètre 3 axes, dit « 3A3M »), une branche de détection 200 peut être sensible à la combinaison de l'accélération et du champ magnétique *α x a* + *B,* où *a* est un mesurande, *B* la valeur du champ magnétique. Si la branche de référence 100 est conçue de manière à être sensible à l'accélération *α* x *a*, le signal de mesure *Vₘ* permet d'obtenir la valeur du champ magnétique *B* seul. De même, il est envisageable de partir d'une configuration où la branche de référence 100 est sensible au mesurande *a* et une branche de détection 200 au mesurande *a*, alors le signal de mesure *Vₘ* produit est sensible à ce même mesurande *Vₘ* = *2a*. Cependant, dans ces deux situations, le signal présent sur la branche de référence 100 est retranché à l'ensemble des branches de détection 200. Ce mode de réalisation est particulièrement avantageux dans le cas où toutes les branches de détection 200 sont affectées de la même manière par ce même mesurande.

La **figure 6** illustre un mode de réalisation où deux plots de mesure additionnels 56 ont été ajoutés dans un montage dans le but de contrôler la tension de polarisation *Vₚ* des branches de détection 200. Ces plots de mesure additionnels 56 positionnés préférentiellement sur le substrat 300, permettent avantageusement de mesurer la tension de pont et fournir ainsi une correction au signal de mesure *Vₘ.* Le rapport entre ces deux signaux permet en effet d'éliminer l'influence des dipôles extra-pont. Ces plots de mesure additionnels 56 d'accès peuvent comporter des dipôles 35 (par exemple, des résistances) instables ou/et de valeur importante comme ceux produits lors d'un scellement eutectique entre deux matériaux, par exemple entre de l'or (Au) et du silicium (Si). Leur impact est d'autant plus négligeable que l'impédance d'entrée de l'étage de mesure de tension est importante.
Les différentes branches de détection 200 présentes dans le montage peuvent dans certaines situations avoir des effets l'une sur l'autre. Si les dipôles 25 ne sont pas parfaitement équilibrés au sein de chaque branche de détection 200 et/ou ne possèdent pas la même sensibilité, l'impédance globale de l'ensemble des branches de détection 200 et référence peut être modifiée. Cet effet peut ensuite se répercuter sur l'impédance globale du montage multi-pont dans lequel les impédances des branches de détection 200 sont mises en parallèle. Ceci a pour effet d'altérer la tension de polarisation effectivement appliquée aux bornes des branches de détection 200. La solution proposée permet de répondre à ce problème. D'un point de vue électrique, la perturbation perçue par chaque branche de détection 200 est identique à celle dans laquelle des dipôles 35 extra-pont modifient la tension de polarisation du montage multi-pont.

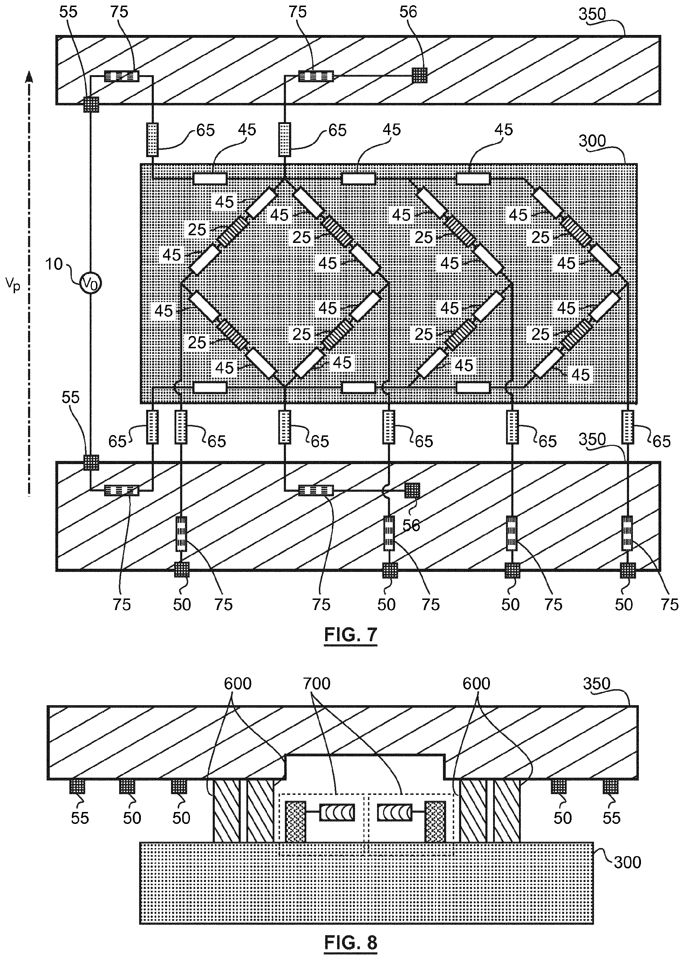

La **figure 7** est une représentation schématique du circuit électrique formant en partie le capteur de mesure selon la présente invention. Avantageusement, la branche de référence 100 et les branches de détection 200 sont situées sur un premier substrat 300, formant de préférence un microsystème électromécanique. Selon un autre mode de réalisation, les plots 50, 55, 56 sont positionnés sur le premier substrat 300 et/ou sur le deuxième substrat 350. Selon un mode de réalisation particulièrement avantageux, les plots 50, 55, 56 sont positionnés uniquement sur un deuxième substrat 350. Avantageusement, les premier et deuxième substrats 300, 350 sont en un matériau semi-conducteur. Les substrats 300, 350 peuvent, par exemple, être formés à base de silicium.
Les dipôles qui relient les transducteurs avantageusement passifs 25 au substrat 300 constituent des dipôles parasites intra-pont 45. Afin de réduire les problèmes de résistances, il convient de réduire autant que possible les dipôles parasites intra-pont 45. On peut considérer que ces dipôles auront un impact négligeable sur le fonctionnement du capteur si leur valeur n'excède pas 1 % de l'impédance des transducteurs avantageusement passifs 25. Cette valeur est acceptable si, par exemple, la stabilité de ces dipôles parasites est avérée à 1%. Dans ce cas, la perturbation globale apportée à la branche de détection 200 est de l'ordre de 100 parties par million (ppm) de la valeur de l'impédance du transducteur 25. Ce niveau de perturbation doit être inférieur à la variation minimale recherchée pour ce même transducteur 25.
Selon ce mode de réalisation avantageux, mais non limitatif de l'invention, les dipôles parasites extra-pont 65, 75 se situent tous à l'extérieur du montage multi-pont. Dans le cas où des dipôles d'accès intra-pont 45 subsistent entre les transducteurs avantageusement passifs 25, ceux-ci peuvent être intégrés aux impédances des transducteurs avantageusement passifs 25 si leur comportement vis-à-vis des grandeurs d'influence est identique.
Dans ce cas de figure, la tension de polarisation appliquée au niveau des deux noeuds d'interconnexion des branches 100, 200 peut être altérée par ces dipôles parasites extra-pont 65, 75.
En outre, le procédé de fabrication peut générer des dipôles parasites 65 d'interconnexion élevés. Tel est le cas lorsque un scellement métallique, par exemple de type eutectique (or-silicium (Au-Si), aluminium-germanium (Al-Ge) or-étain (Au-Sn), etc.)), est requis afin d'interconnecter des pistes conductrices d'un premier substrat 300 à un deuxième substrat 350. La valeur du dipôle parasite 65 d'un tel scellement peut être importante. Dans une telle situation, les dipôles parasites 65 du scellement doivent préférentiellement être disposés à l'extérieur des ponts de Wheatstone, par exemple au niveau de l'interface entre le premier et un deuxième substrat 350, différent du premier substrat 300, comprenant les ponts de Wheatstone. Il convient pour cela d'interconnecter les transducteurs avantageusement passifs 25 des ponts en aval de ces dipôles parasites 65, par rapport aux plots 55 de polarisation et/ou plots de mesure additionnels 56. Selon un exemple de réalisation, cela peut être réalisé au moyen d'une couche continue de matériaux conducteurs électriques. Cette couche peut se composer, par exemple, de silicium dopé et d'un métal tel que l'aluminium. L'utilisation d'un matériau de bonne conductivité permet en effet de réduire efficacement les dipôles des pistes entre deux transducteurs 25 grâce à un dimensionnement des pistes adéquat. Par exemple, des pistes d'impédance inférieure à 1 Ohm peuvent être fabriquées avec une couche de silicium et d'aluminium et être négligeables face aux transducteurs avantageusement passifs 25 d'impédances proches de 2000 Ohms. La disposition, proposée, apporte ainsi une solution au problème dans lequel des dipôles de contact de valeur importante ou de comportement instable peuvent apparaître lors du scellement d'un premier substrat 300 et d'un deuxième substrat 350, au niveau de leurs plots 50, 55, 56. On obtient ainsi une discontinuité entre les conducteurs du premier substrat 300 et du deuxième substrat 350.
Dans le schéma de la figure 7, les dipôles parasites 65 de valeur élevée du scellement métallique sont positionnés en dehors des ponts, et sont exclus du circuit de mesure, si leur dipôle est faible devant l'impédance d'entrée de l'étage de mesure des tensions *Vₚ* et *Vₘ.*

La **figure 8** illustre une représentation schématique du capteur. Un premier substrat 300 comprend préférentiellement un microsystème électromécanique formé au moins d'un circuit électrique, de pistes d'interconnexion 600 et de jauges 700. Le premier substrat 300 comprend avantageusement des pistes d'interconnexions 600 configurées de sorte à acheminer les informations (par exemple, les grandeurs physiques, le signal électrique) d'un plot 50, 55, 56 à un autre. Un deuxième substrat 350 est avantageusement scellé au premier substrat 300 au moyen d'un scellement de pistes d'interconnexion 600, de sorte à former une cavité accueillant au moins les jauges 700. Les jauges 700 sont, selon un mode de réalisation préférentiel, de type piézo-résistif. Par exemple, avec des capteurs à jauges, une déformation élastique de l'élément de mesure est tout d'abord convertie en une variation de résistance de la jauge, pour générer ensuite un signal de sortie électrique d'un circuit de pont de Wheatstone. Avantageusement, le circuit comprend au moins une masse mobile.
Selon un mode de réalisation particulièrement avantageux, les plots 50, 55, 56 sont positionnés sur un deuxième substrat 350.
La figure 8 représente un capteur à deux mesurandes. Dans ce cas, 5 plots 50, 55, 56 sont positionnés sur le deuxième substrat 350 : soit 2 plots 55 pour la polarisation, 1 plot de mesure central 50 pour la branche de référence 100 et 2 plots de mesure 50 pour les 2 mesurandes extraits à partir des deux branches de détection 200.

Le tableau ci-après compare le nombre de plots 50, 55, 56 nécessaire sur le substrat 300 afin de réaliser diverses configurations. Dans cet exemple de réalisation, deux transducteurs avantageusement passifs 25 sont présents sur chaque branche de détection 200. Chaque configuration proposée dans le tableau permet de remédier à certains problèmes pouvant être rencontrés, en pratique, lors de la mise en place d'un montage de mesure (par exemple, des problèmes liés aux branches 200 déséquilibrées du pont de Wheatstone, aux dipôles parasites 45, 65, 75, etc.). De manière particulièrement avantageuse, le montage, selon la présente invention, permet un gain (soit une réduction) en termes de nombre de plots 50, 55, 56 pour chaque situation, quel que soit le nombre de mesurandes n, en particulier pour un nombre n supérieur à 1.

| CONFIGURATION | Nombre de plots 50, 55 pour n mesurandes, obtenu selon l'invention | Nombre de plots 50, 55 pour n mesurandes, obtenu selon l'art antérieur |
|---|---|---|
| Montage de base | n + 2 | 3 x n |
| Montage avec un branche de référence 100 intégrée à un substrat 300 | n + 3 | 4 x n |
| Montage avec des plots additionnels 56 pour le contrôle de la tension de polarisation | n + 5 | 6 x n |

La mise en commun de la source de polarisation 10 pour l'ensemble des branches de détection 200 ne permet pas de contrôler, mesurande par mesurande, l'état de polarisation des transducteurs avantageusement passifs 25. Lorsque la source de polarisation 10 est activée, tous les transducteurs 25 sont polarisés, et inversement. La tension de polarisation peut être activée de manière intermittente à une fréquence élevée (10³ à 10⁴ kHz), avec un faible rapport cyclique (par exemple, inférieur à 0.2).

Deux méthodes peuvent, en particulier, être envisagées. La première consiste en n étages de conditionnement de signal pouvant être intégrés au sein du circuit intégré propre à une application (en anglais, acronyme « ASIC » pour « Application-Specific Integrated Circuit »), afin d'adresser chaque composant simultanément. Cette solution peut cependant nécessiter des ressources importantes (par exemple, concernant l'espace occupé, la consommation énergétique, etc.) pour l'électronique de lecture. La deuxième méthode concerne l'utilisation de buffers (de type échantillonneur bloqueur, par exemple) pour chaque mesurande, permettant de conserver la tension de milieu de pont en vue d'un conditionnement ultérieur. Cette solution requiert alors un seul étage de conversion analogique numérique, voire un seul étage d'amplification analogique.

La présente invention n'est pas limitée aux modes de réalisation précédemment décrits mais s'étend à tout mode de réalisation couvert par les revendications. En outre, le circuit de mesure n'exclut pas la présence d'autres parties, dont des ponts de Wheatstone indépendants en plus.

## Revendications

1. Circuit de mesure pour un capteur multi-sensoriel comprenant :
- une pluralité de branches de détection (200) montées en parallèle, chacune comprenant au moins deux dipôles (25) montés en série,
- et, au moins une branche de référence (100), comprenant une source de polarisation (10) et au moins deux dipôles (25) montés en série; **caractérisé en ce que** ladite branche de référence (100) étant électriquement reliée en parallèle à au moins deux branches de détection (200) parmi la pluralité de branches, de sorte à former un pont de Wheatstone avec chacune des branches de détection (200) parmi la pluralité de branches de détection (200).

2. Circuit selon la revendication précédente comprenant au moins un dipôle (25) à impédance variable en fonction de l'évolution d'un mesurande dans au moins une branche de détection (200).

3. Circuit selon l'une quelconque des revendications précédentes dans lequel la branche de référence (100) est reliée aux branches de détection (200) au moyen d'un premier plot et d'un deuxième plot de polarisation (55).

4. Circuit selon l'une quelconque des revendications précédentes dans lequel chaque branche de détection (200) est reliée à au moins un plot de mesure central (50) situé entre les dipôles (25) de ladite branche de détection, au point milieu des branches de détection (200).

5. Circuit selon l'une quelconque des revendications précédentes comprenant deux plots de mesure additionnels (56) montés en parallèle et configurés de sorte à contrôler la tension de polarisation des branches de détection (200).

6. Capteur multi-sensoriel comprenant au moins un circuit de mesure selon l'une quelconque des revendications précédentes.

7. Capteur selon la revendication précédente dans lequel le circuit de mesure est formé en partie au moins sur un premier substrat (300) et un deuxième substrat (350); lesdits substrats (300, 350) étant assemblés de sorte à former une cavité.

8. Capteur selon la revendication précédente comprenant un circuit selon la revendication 5 dans lequel la branche de référence (100) est reliée en parallèle aux branches de détection (200) au moyen du premier plot et du deuxième plot de polarisation (55) ; lesdits plots de mesure central (50) et additionnels (56) ainsi que les plots de polarisation (55) étant situés sur le premier et/ou sur le deuxième substrat (350).

9. Capteur selon l'une quelconque des deux revendications précédentes dans lequel la branche de référence (100) est, en partie au moins, positionnée sur le premier substrat (300).

10. Capteur selon l'une quelconque des trois revendications précédentes dans lequel la branche de référence (100) est en partie au moins positionnée sur le deuxième substrat (350).

11. Capteur selon l'une quelconque des quatre revendications précédentes dans lequel chaque branche de détection (200) est en partie au moins positionnée sur le premier substrat (300).

12. Capteur selon l'une quelconque des cinq revendications précédentes dans lequel chaque branche de détection (200) est reliée à au moins un plot de mesure central (50) ; ledit plot de mesure central (50) étant situé sur le deuxième substrat (350) ou sur le premier substrat (300).

13. Capteur selon l'une quelconque des six revendications précédentes comprenant un microsystème et/ou nanosystème électromécanique.

14. Capteur selon la revendication précédente dans lequel le microsystème et/ou nanosystème électromécanique est situé dans la cavité.

15. Capteur selon l'une quelconque des deux revendications précédentes dans lequel le microsystème et/ou nanosystème électromécanique comporte au moins une masse mobile.

16. Capteur selon l'une quelconque des trois revendications précédentes dans lequel le microsystème et/ou nanosystème électromécanique est réalisé sur le premier substrat (300).

17. Capteur selon l'une quelconque des revendications 6 à 16 dans lequel le premier substrat (300) comprend des pistes d'interconnexion (600).

## Patentansprüche

1. Messschaltung für einen multisensorischen Messwertaufnehmer, umfassend:
- eine Vielzahl von Erfassungselementen (200), die parallel montiert sind, wobei jedes mindestens zwei in Serie montierte Dipole (25) umfasst,
- und mindestens ein Referenzelement (100), umfassend eine Polarisationsquelle (10) und mindestens zwei in Serie montierte Dipole (25),
**dadurch gekennzeichnet, dass** das Referenzelement (100) elektrisch parallel mit mindestens zwei Erfassungselementen (200) unter der Vielzahl von Elementen verbunden ist, um eine Wheatstone-Brücke mit jedem der Erfassungselemente (200) unter der Vielzahl von Erfassungselementen (200) zu bilden.

2. Schaltung nach dem vorhergehenden Anspruch, umfassend mindestens einen Dipol (25) mit variabler Impedanz in Abhängigkeit von der Entwicklung einer Messgröße in mindestens einem Erfassungselement (200).

3. Schaltung nach einem der vorhergehenden Ansprüche, bei der das Referenzelement (100) mit den Erfassungselementen (200) mit Hilfe eines ersten Polarisationsblocks und eines zweiten Polarisationsblocks (55) verbunden ist.

4. Schaltung nach einem der vorhergehenden Ansprüche, bei der jedes Erfassungselement (200) mit mindestens einem zentralen Messblock (50), der sich zwischen den Dipolen (25) des Erfassungselements befindet, am Mittelpunkt der Erfassungselemente (200) verbunden ist.

5. Schaltung nach einem der vorhergehenden Ansprüche, umfassend zwei zusätzliche Messblöcke (56), die parallel montiert und dazu vorgesehen sind, die Polarisationsspannung der Erfassungselemente (200) zu kontrollieren.

6. Multisensorischer Messwertaufnehmer, umfassend mindestens eine Messschaltung nach einem der vorhergehenden Ansprüche.

7. Messwertaufnehmer nach dem vorhergehenden Anspruch, bei dem die Messschaltung zumindest teilweise auf einem ersten Substrat (300) und einem zweiten Substrat (350) gebildet ist; wobei die Substrate (300, 350) zusammengefügt sind, um einen Hohlraum zu bilden.

8. Messwertaufnehmer nach dem vorhergehenden Anspruch, umfassend eine Schaltung nach Anspruch 5, bei der das Referenzelement (100) parallel mit den Erfassungselementen (200) mit Hilfe des ersten Polarisationsblocks und des zweiten Polarisationsblocks (55) verbunden ist; wobei die zentralen (50) und zusätzlichen (56) Messblöcke sowie die Polarisationsblöcke (55) auf dem ersten und/oder auf dem zweiten Substrat (350) angeordnet sind.

9. Messwertaufnehmer nach einem der vorhergehenden Ansprüche, bei dem das Referenzelement (100) zumindest teilweise auf dem ersten Substrat (300) positioniert ist.

10. Messwertaufnehmer nach einem der drei vorhergehenden Ansprüche, bei dem das Referenzelement (100) zumindest teilweise auf dem zweiten Substrat (350) positioniert ist.

11. Messwertaufnehmer nach einem der vier vorhergehenden Ansprüche, bei dem jedes Erfassungselement (200) zumindest teilweise auf dem ersten Substrat (300) positioniert ist.

12. Messwertaufnehmer nach einem der fünf vorhergehenden Ansprüche, bei dem jedes Erfassungselement (200) mit mindestens einem zentralen Messblock (50) verbunden ist; wobei der zentrale Messblock (50) auf dem zweiten Substrat (350) oder auf dem ersten Substrat (300) angeordnet ist.

13. Messwertaufnehmer nach einem der sechs vorhergehenden Ansprüche, umfassend ein elektromechanisches Mikrosystem und/oder Nanosystem.

14. Messwertaufnehmer nach dem vorhergehenden Anspruch, bei dem das elektromechanische Mikrosystem und/oder Nanosystem in dem Hohlraum angeordnet ist.

15. Messwertaufnehmer nach einem der zwei vorhergehenden Ansprüche, bei dem das elektronmechanische Mikrosystem und/oder Nanosystem mindestens eine mobile Masse umfasst.

16. Messwertaufnehmer nach einem der drei vorhergehenden Ansprüche, bei dem das elektromechanische Mikrosystem und/oder Nanosystem auf dem ersten Substrat (300) hergestellt ist.

17. Messwertaufnehmer nach einem der Ansprüche 6 bis 16, bei dem das erste Substrat (300) Verbindungsspuren (600) umfasst.

## Claims

1. A measuring circuit for a multisensory detector comprising:
- a plurality of detection branches (200) mounted in parallel, with each one comprising at least two dipoles (25) mounted in series,
- and, at least one reference branch (100), comprising a polarizing source (10) and at least two dipoles (25) mounted in series;
**characterized in that**
said at least one reference branch (100) being electrically connected in parallel to at least two detection branches (200) among the plurality of branches, so as to form a Wheatstone bridge with each one of the at least two detection branches (200) among the plurality of detection branches (200).

2. A circuit according to the preceding claim comprising at least one dipole (25) having a variable impedance according to the evolution of a measurand in at least one detection branch (200).

3. A circuit according to any one of the preceding claims, wherein the at least one reference branch (100) is connected to the at least two detection branches (200) by means of a first polarizing pad and of a second polarizing pad (55).

4. A circuit according to any one of the preceding claims, wherein each one of at least two detection branches (200) is connected to at least one central measuring pad (50) located between the at least two dipoles (25) of said at least two detection branches, at the mid-point of the at least two detection branches (200).

5. A circuit according to any one of the preceding claims, comprising two additional measuring pads (56) mounted in parallel and so configured as to control the polarizing voltage of the at least two detection branches (200).

6. A multisensory detector comprising at least one measuring circuit according to any one of the preceding claims.

7. A detector according to the preceding claim, wherein the measuring circuit is at least partially formed at least on a first substrate (300) and a second substrate (350); with said first and second substrates (300, 350) being assembled so as to form a cavity.

8. A detector according to the preceding claim comprising a circuit according to claim 5, wherein the at least reference branch (100) is connected in parallel to the at least two detection branches (200) by a first polarizing pad and of a second polarizing pad (55); with said central measuring pad (50) and additional pad (56) as well as the polarizing pads (55) being located on the first and/or on the second substrate (350).

9. A detector according to any one of the preceding two claims, wherein the at least one reference branch (100) is, at least partially, positioned on the first substrate (300).

10. A detector according to any one of the preceding three claims, wherein the at least one reference branch (100) is at least partially positioned on the second substrate (350).

11. A detector according to any one of the preceding four claims, wherein each of the at least two detection branches (200) is at least partially positioned on the first substrate (300).

12. A detector according to any one of the preceding five claims, wherein each of the at least two detection branches (200) is connected to at least one central measuring pad (50); with said central measuring pad (50) being located on the second substrate (350) or on the first substrate (300).

13. A detector according to any one of the preceding six claims comprising a microelectromechanical and/or nanoelectromechanical system.

14. A detector according to the preceding claim, wherein the microelectromechanical and/or nanoelectromechanical system is located in the cavity.

15. A detector according to any one of the preceding two claims, wherein the microelectromechanical and/or nanoelectromechanical system comprises at least one mobile mass.

16. A detector according to any one of the preceding three claims, wherein the microelectromechanical and/or nanoelectromechanical system is provided on the first substrate (300).

17. A detector according to any one of claims 6 to 16, wherein the first substrate (300) comprises interconnection tracks (600).
